(19) **Europäisches Patentamt**

**European Patent Office**

**Office européen des brevets**

(11) **EP 0 706 663 B2**

(12) ## NEW EUROPEAN PATENT SPECIFICATION

(45) Date of publication and mention
of the opposition decision:
**12.11.2003 Bulletin 2003/46**

(45) Mention of the grant of the patent:
**01.10.1997 Bulletin 1997/40**

(21) Application number: **94918977.3**

(22) Date of filing: **30.06.1994**

(51) Int Cl.7: **G01R 31/42**, G01R 27/16

(86) International application number:
**PCT/GB94/01420**

(87) International publication number:
**WO 95/001573 (12.01.1995 Gazette 1995/03)**

(54) **ELECTRICAL TEST INSTRUMENT**

ELEKTRISCHES TESTGERÄT

INSTRUMENT DE TEST ELECTRIQUE

(84) Designated Contracting States:
**DE ES FR GB IT SE**

(30) Priority: **01.07.1993 GB 9313602**

(43) Date of publication of application:
**17.04.1996 Bulletin 1996/16**

(73) Proprietor: **Avo International Limited
Dover, Kent CT17 9EN (GB)**

(72) Inventor: **GURR, David, James
Kent ME8 0HU (GB)**

(74) Representative: **Finnie, Peter John et al
Gill Jennings & Every,
Broadgate House,
7 Eldon Street
London EC2M 7LH (GB)**

(56) References cited:
**EP-A- 0 278 147          EP-A- 0 295 800
DE-A- 2 016 408          GB-A- 2 239 530
GB-A- 2 292 225**

- **IEEE 1982, Survey of Low Ground Electrode Impedance Measurements**
- **Schaltplan 1856-01 BS 140 "Unilap 100"**
- **Adapteur Ohmmètre de terre CRT2010**

EP 0 706 663 B2

## Description

### TECHNICAL FIELD

The impedance of the phase - earth loop in an AC power supply is very important and all new installations and electrical modifications have to be tested to verify this impedance. This test is mandatory under current I. E.E. regulations in the United Kingdom. The impedance of a correctly wired phase - earth loop is typically in the range 0.01 Ω to 1 Ω.

### BACKGROUND ART

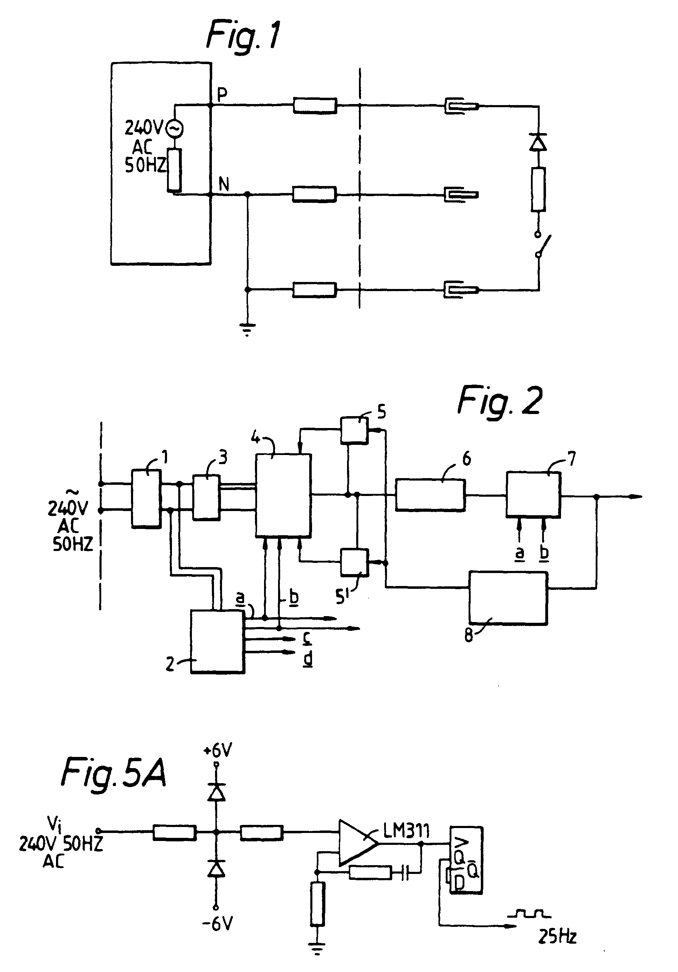

Test methods and equipment have been developed to establish the impedance of the phase - earth loop. A first example is shown in Figure 1. The test is made by measuring the voltage between the phase and earth lines with and without a test resistor of a known value in the circuit. The two test voltages are then compared to determine the phase - earth impedance. During the test with the resistor in circuit a current flows in the phase - earth loop. To obtain a reasonable impedance measurement the value of the test resistor must be low, typically 10 Ω, and the value of the test current which flows to earth is correspondingly high, typically 20 A. In unprotected circuits these known methods and equipment operate satisfactorily. However, with circuits including earth - leakage circuit breakers for protecting the users and connected equipment, there are problems as the test current causes the circuit breaker to trip before the test can be completed.

A typical circuit breaker used for protection on AC mains supplies is the residual current circuit breaker (RCCB), which detects any imbalance in the current flow in the phase - neutral loop. Usually this is caused by current passing from the phase line to earth. The RCCB has a magnetically coupled sensing circuit which is sensitive to the current balance in the phase - neutral loop. When the conventional test described above is carried out, the test current flows only in the phase - earth loop, so that an RCCB detects a current imbalance between the phase and neutral lines and is triggered.

A method of overcoming the inherent problems of testing RCCB protected AC circuits is described in European Patent No. 0,295,800B which discloses a method of temporarily disabling an RCCB by injecting a saturating DC current into the protected circuit, which increases the magnetisation of the magnetic circuit towards saturation thereby disabling the sensing circuit of the RCCB, i.e. imbalance current fluctuations in the phase - neutral loop will not be sensed. Hence a conventional 20 A test current may then be used to determine the loop impedance in the manner described above.

The operating instructions accompanying the Norma Messtechnik, Optik, Elektronik GmbH "GO-MAT electronic" discloses a procedure for testing RCCB protected AC circuits using a test current that is less than the circuit breaker trigger current rating.

In one mode a switch is used to apply a resistive load across the mains supply for one complete cycle and to remove the load on the following cycle. The application of the resistive load is synchronised with the mains supply and is applied at a repetition frequency of half that of the mains supply. The loop resistance is computed from the difference of the terminal voltage between the loaded and unloaded cycles and the load current.

### DISCLOSURE OF INVENTION

According to a first aspect of the present invention, a method of testing a loop impedance in a circuit breaker protected AC circuit is as defined in claim 1.

Preferably, a test current less than or equal to half the rated circuit breaker trigger current is used as the test current.

Preferably the test current is substantially 15 mA. A test current of this value is low enough not to trigger the majority of commercially available circuit breakers whilst permitting detection of the test voltage signal with sufficient accuracy.

According to a second aspect of the present invention, an apparatus for testing a circuit breaker protected AC circuit to determine a loop impedance is described in claim 4.

N-path filters are an established form of high selectivity band pass filters. A series switched N-path filter comprises a plurality of input paths with each path including an input switch, an output switch, and a capacitor coupled between the path intermediate the two switches and earth. They are used to preserve the magnitude of a particular frequency while attenuating all others. A detailed description and analysis of the performance of N-path filters is given in the publication entitled "Analog switches and their applications", Dec. 1976, Siliconix, Siliconix Incorporated, Chapter 5.

Preferably, the N-path filter comprises a series switched N-path filter in which each path has its input switch and output switch driven out of phase and each switch is synchronised with one other switch in another path.

Where a particular frequency $F_m$ in a signal dominates, i.e. the 50 Hz signal in the United Kingdom 240 V AC mains supply, the centre frequency, $F_o$, of the N-path filter should be selected to reject the dominant frequency $F_m$ by making

$$F_o = F_m/N$$

Hence, to reject the 50 Hz signal and its harmonics in a 240 V AC 50 Hz mains supply, a centre frequency $F_o$ of 25 Hz and a filter with with two paths (N = 2) should be chosen. Likewise, to reject a 60 Hz signal the filter should be arranged such that $F_o = 30$ Hz and $N = 2$.

In the present invention, provided that whilst an input switch in any path of the series switched cross synchronised N-path filter is closed for one complete cycle of a dominant unwanted 240 V AC mains supply signal whilst the associated cross synchronised output switch in another path is also closed during the same cycle, the filter can output consecutive signals which are representative of various levels of the input test signal. Hence a two path filter can be arranged to output the positive rms and negative rms of the varying input test signal, whilst a three path filter could also output a third intermediate level and so on. For example, a five path filter can be realised by cross synchronising the switches in the five paths at a frequency of 10 Hz (1:4 mark/space ratio) and using a 10 Hz sine wave test current. Only one output switch will be closed at any moment in time so that there will be five discrete DC output levels relative to a DC offset over any complete test current cycle. These signals approximate to a sine wave of frequency 10 Hz. The advantage of this cross synchronised filter over conventionally switched filters is that rather than simply giving high attenuation of frequencies $kNF_0$, a cross synchronised filter gives total AC rejection of a steady input signal of frequency $kNF_0$, leaving only a DC offset.

In typical applications all input frequencies are limited to less than $NF_0/2$ to avoid aliasing. With the cross synchronised filter it is essential that a dominant frequency $NF_0$ is present.

In the case where an AC mains supplied circuit is to be tested, preferably the N-path filter comprises a two path cross synchronised filter with a centre frequency of half the mains frequency.

Preferably, in accordance with the method of the present invention, a two path cross synchronised filter is used to reject the AC supply signal thereby isolating the test voltage signal.

A form of 25 Hz test current is required. For circuit simplicity, preferably a 'quasi 25 Hz' test current supply means is used which generates a 50 Hz, fifty percent duty cycle, 15 mA (rms) current which utilises alternate halves of a 240 V AC mains supply cycle.

Preferably the apparatus further comprises a mains synchronisation circuit which controls the test current signal output of the test current supply means and generates a centre frequency signal, $F_o$, which is synchronised with the 50 Hz mains signal and controls the operation of the two path cross synchronised filter.

Preferably one path of the two path filter includes a variable resistor to enable the RC ratios of the two input paths of the filter to be closely matched. This helps to ensure a good rejection of the 240 V AC mains signal.

The test voltage output of the filter when using the 15 mA test current described above is a square wave which includes a DC offset. The apparatus may further comprise a DC decoupler circuit connected to the output of the two path filter to remove the unwanted DC level. In this case, preferably the output of the DC decoupling circuit is connected to a phase sensitive detector. However, preferably the test voltage output of the filter is applied to two parallel circuit paths, each path comprising a switch and a charging capacitor coupled to earth wherein the switches in each path are driven out of phase with respect to one another and the output of each path is connected to a differential amplifier. This circuit arrangement also has the effect of removing the DC offset.

In both cases, the output of the circuit is a test voltage level which is approximately constant. This voltage is typically 0.15 mV to 15 mV and is representative of the loop resistance. Given that the test current which generates this voltage signal is known, the loop resistance may be calculated by applying Ohms' law. Preferably the apparatus further comprises micro-processor means to calculate the loop resistance. Preferably, the apparatus also includes display means for displaying the calculated value of the loop resistance.

In use, the apparatus is housed in a test unit which has the appropriate leads to allow the test unit to be connected across the terminals of the phase - earth loop or the phase - neutral loop of the AC circuit to allow an impedance measurement to be made. Normally, the inductive impedance of a loop is negligible and need not be measured. However, a function of the impedance can be measured by applying signals to the filter circuit which are 90° out of phase with the test current control circuit. Having previously measured the resistive component, the inductance can be deduced, and then the true impedance calculated.

As the 240 V AC mains supply is not ideal, there are occasions when noise may occur. This will affect the validity of any impedance calculation. To improve the accuracy of the apparatus, preferably the apparatus includes noise detection and error correction means which detect if noise has occurred and adjust the magnitude of the voltage output signal from each filter path to make it approximately equal to the previous voltage output level. Preferably the error correction means for the outputs of each path of the filter comprises a memory capacitor which stores the output level of a filter path during the end part of an output cycle and which is selectively connected by switching means controlled by the noise detection means to the path capacitor during the start of the next output cycle to refresh the output signal level if the signal level has changed by above a pre-determined limit since the last detected output of that path due to noise.

## BRIEF DESCRIPTION OF DRAWINGS

An example of the present invention will now be described with reference to the accompanying drawings, in which:-

Figure 1 shows a conventional test apparatus;

Figure 2 shows a block diagram of one example of a test apparatus in accordance with the present invention;

Figure 3A shows a test current control circuit;

Figure 3B shows the signals associated with the test circuit of Figure 3A;

Figure 4 shows an example of a two path cross synchronised filter;

Figure 5A shows a mains synchronisation circuit;

Figure 5B shows control signals applied to an error correction facility of Figure 10;

Figure 6 shows an output signal obtained from the circuit of Figure 4;

Figure 7 shows a DC decoupler circuit;

Figure 8 shows a phase sensitive detector circuit;

Figure 9 shows an output of the phase sensitive detector circuit of Figure 8;

Figure 10 shows an error correction facility of the present invention; and

Figures 11 A and 11 B show another embodiment of the DC removal and error correction facility.

## DESCRIPTION

Figure 2 shows a block diagram of one example of a loop test apparatus in accordance with the present invention. The test apparatus comprises a test current control circuit 1, a mains synchronisation and filter control circuit 2, an RC ratio matching circuit 3, a cross synchronised two path filter circuit 4, error correction circuits 5, 5', a DC decoupling circuit 6, a phase sensitive detector 7 and a noise detection circuit 8.

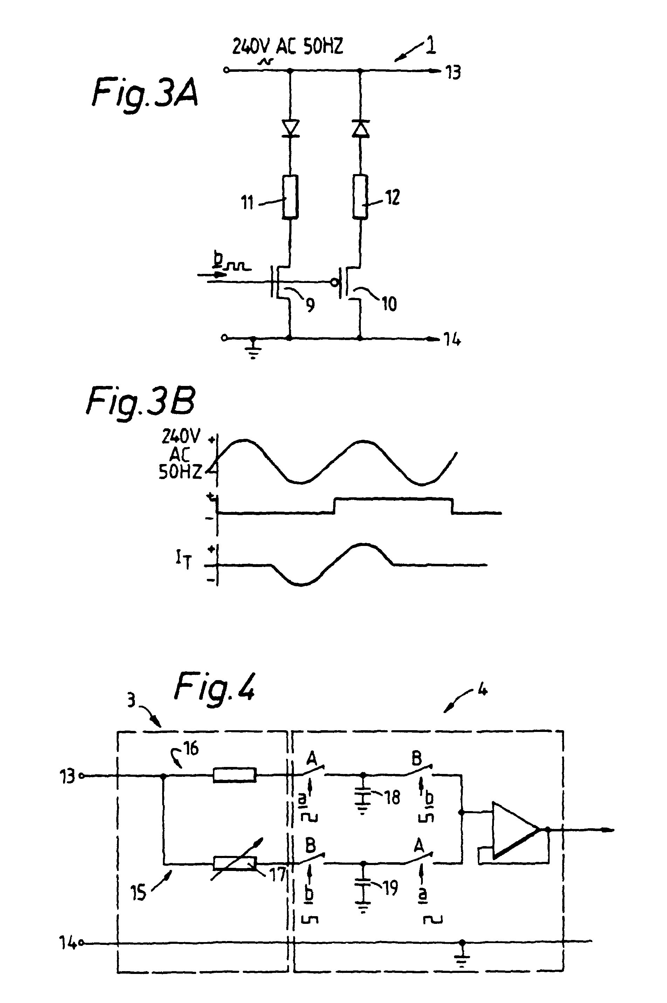

The test current control circuit 1 is shown in Figure 3A. The circuit is shown connected across the phase - earth lines of the mains but may equally be applied to the phase - neutral Is to make an impedance measurement of the phase - neutral loop. A 25 Hz square wave signal is used to operate MOSFETS 9, 10 which act as switches with a fifty percent duty cycle whereby alternate halves of the mains cycle are applied. The circuit operates to allow a test current of approximately 15 mA (rms) to flow around the mains phase - earth loop. The test current, $I_{test}$, is not large enough to trigger most RC-CBs or other circuit breaker protection. The value of the test current is determined by the value of the resistors 11, 12 which are typically in the order of 16 k$\Omega$ each. The test current output has a fifty percent duty cycle and is shown in Figure 3B. An alternative test current may be obtained using only a single MOSFET which generates a +15 mA (50% duty cycle) and 0 mA test current.

A voltage proportional to the loop resistance with the same wave shape will appear across the terminals 13, 14 and it is this voltage which must be measured to determine the loop resistance. However, as the loop resistance is usually very low, i.e. 0.01 $\Omega$ to 1 $\Omega$, the test voltage is correspondingly low and typically only 0.15 mV to 15 mV. This signal is impressed upon the 240 volts AC mains voltage and therefore at this stage is undetectable. Accordingly, the mains voltage must be substantially rejected to leave only the small test voltage signal before any resistance calculation can be made.

The output of the test current control circuit 1 is applied to the inputs of the two path filter circuit 4 shown in Figure 4. The input to one of the paths 15 of the filter includes a variable resistor 17 which is used to match the RC ratios of each of the filter paths 15, 16. This is important to achieve a good rejection of the mains voltage.

Each path 15, 16 of the filter comprises an input switch and an output switch A, B with a capacitor 18, 19 connected between the two switches and grounded to earth. The switches may be analog CMOS switches. The capacitances of the capacitors 18, 19 are chosen to be approximately equal but the fine tuning of the RC ratio is done using the variable resistor 17. A typical value for the capacitors is 0.1 μf and the RC constant may be 0.2 seconds. The outputs of each path are connected together. It can be seen that in path 16 the input and output switches A, B, respectively, are each driven by a 25 Hz square wave a, b respectively which are 180° out of phase. The square wave signals a, b are generated by the mains synchronisation circuit 2. The same signals are used in path 15. In this manner, the switches in one path are cross synchronised with the switches in the other path. As will be explained in detail below, this results in a very high rejection of the 50 Hz mains signal.

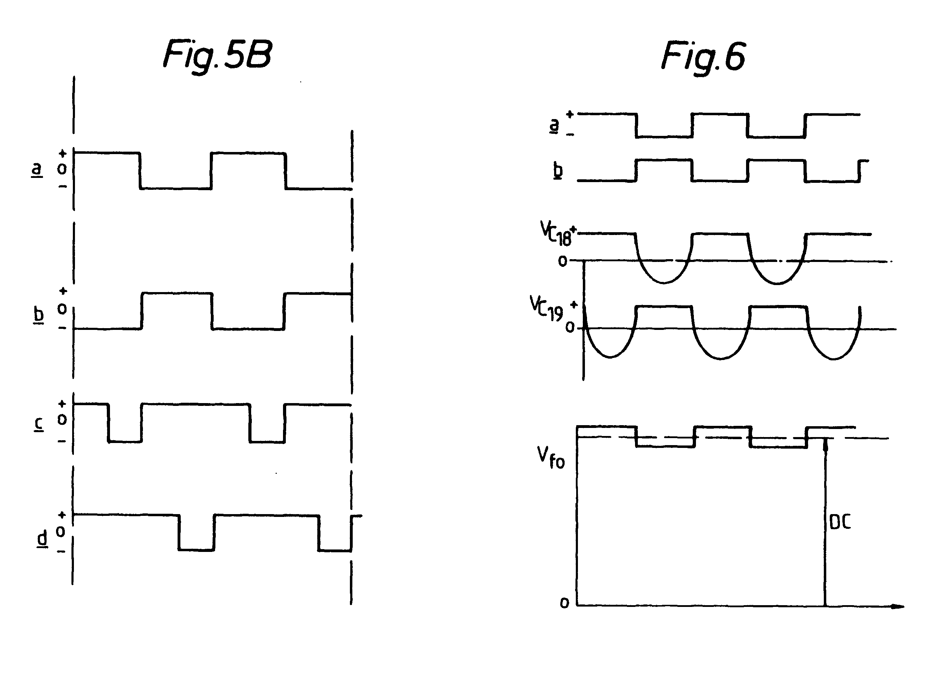

The switches A, B are driven by a pair of signals a, b from the mains synchronisation and filter drive circuit 2. Part of this circuit is shown in Figure 5A and comprises a zero crossing detector which detects the change in polarity of the sinusoidally varying mains signal to produce a 50 Hz square wave. This square wave is subsequently processed using flip-flop circuitry to halve this frequency to 25 Hz. Two 25 Hz signals a, b are output from the mains synchroni-sation circuit 2, each 180° out of phase relative to the other. The output waveforms for this circuit are shown in Figure 5B. Two further waveforms c, d are also generated which are used to control the operation of the error correction circuits 5, 5' (see detailed description below). One of the 25 Hz square wave signals b is used to control the operation of the MOSFET switches 9, 10 of the test current control circuit 1 as explained above. The voltages appearing across the capacitors 18, 19 are shown in Figure 6. The RC constant for each path 15, 16 is chosen to attenuate the mains voltage to within the dynamic range of the circuit. This makes RC large which has the effect of causing the test voltage to take a long time to charge the capacitors. The charging of the capacitors 18, 19 can be considered to be due to the combined effect of the 240 volt AC mains supply together with the additional test voltage resulting from the quasi 25 Hz' 15 mA test current. After an initial charging period, typically one and a half seconds, the effect of the test voltage on a capacitor is a DC value with a very small ripple. Hence the 'quasi 25 Hz' (50 Hz, fifty percent duty cycle) test voltage effectively appears to the capacitors 18, 19 as a 25 Hz square wave, the magnitude equal to the rms voltage of each sense of the fifty per cent duty cycle voltage.

Mains syncrhonisation is a key element of the filter operation. Synchronising with the nominally 50 Hz supply causes total AC rejection of a perfect mains supply. However, if the filter control signals operated at a fixed frequency, then if an imperfect mains supply drifted to 49.5 Hz then aliasing would cause large output variations from the filter. By having direct synchronisation the filter control signal frequency moves with changes in the mains frequency and thus avoids the problem of aliasing.

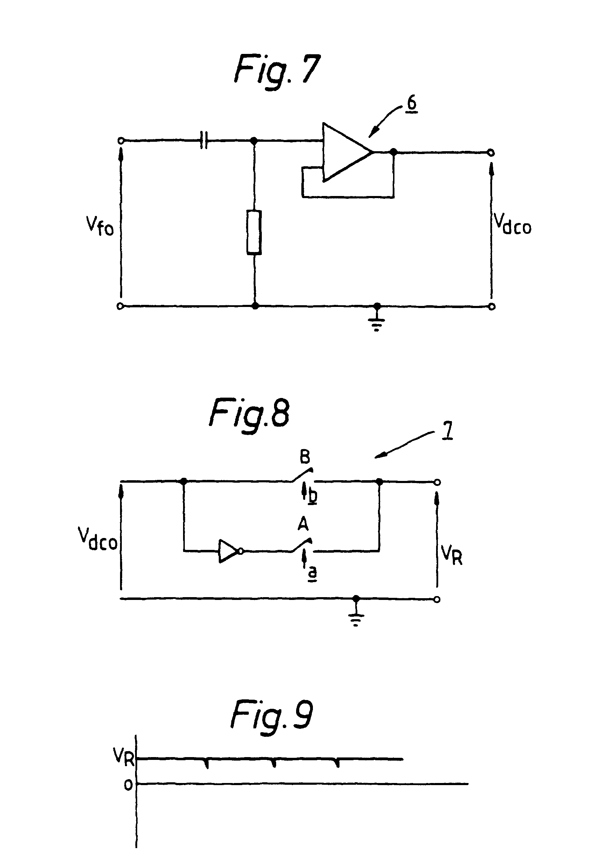

The output of the two path filter circuit 4, $v_{fo}$, is also shown in Figure 6. The signal is a square wave with a DC offset. The DC offset is decoupled using a standard de-coupler circuit 6 shown in Figure 7. The output from the decoupler $V_{dco}$ is applied to a phase sensitive detector circuit 7 which has switches A and B controlled by the same 25 Hz signals $\underline{a}$, $\underline{b}$ generated by the mains synchronisation circuit 2. The output of the phase sensitive detector circuit 7 is shown in Figure 9. The voltage $V_R$ shown in this illustration is a direct result of the 15 mA test current which flows around the loop and is therefore representative of the value of the loop resistance. Given that the current is accurately known and the resultant test voltage, $V_R$, can now be accurately determined, the value of the loop resistance can be calculated and displayed.

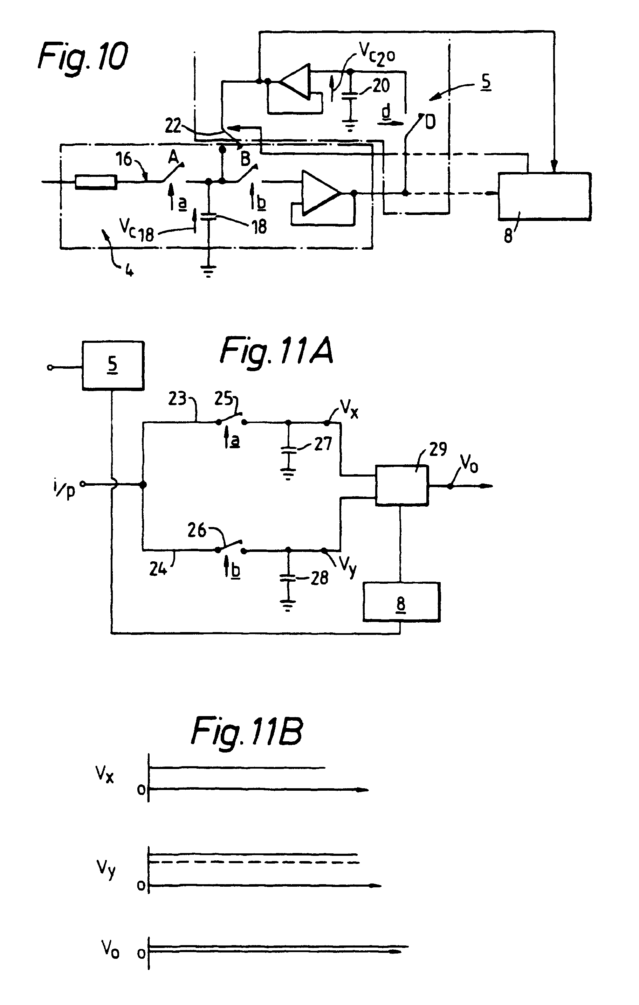

As explained above, the effect of filtering out the mains voltage is to leave a DC offset. If the magnitude and wave shape of the 240 volt 50 Hz signal was constant then the level of this DC offset would be constant. In practice, as no mains supply is ideal, an AC element remains as noise so that the magnitude of the DC offset varies i.e. an AC signal is produced. A feature of the present invention is a noise detector 8 and an error correction circuit 5, 5' which compensates for any significant variations in the mains signal which may affect the output of the two path filter 4. One error detection circuit 5 associated with the path 16 is shown in detail in Figure 10. The waveforms applied to the switches A, B and D are shown in Figure 5B. The signal $\underline{d}$ which operates the switch $\underline{D}$ is generated by the mains synchronisation and filter control circuit 2 (as explained above).

A memory capacitor 20 is charged in the second half of the period when the switch B is closed. When switch B first closes in the following cycle the noise detector circuit 8 compares the voltage $V_{c18}$ across the capacitor 18 with the voltage $V_{C20}$ across the capacitor 20 to decide if noise has occurred, i.e. to see if the voltage across the capacitor 18 has risen or fallen by greater than a pre-determined value compared to the previous cycle. If the potential difference across the capacitor 18 has fallen, the noise detector circuit 8 generates a signal which closes the switch 22 for the first half of the period that switch B is closed to refresh the potential difference across the capacitor 20 back onto capacitor 18. Hence the variation in the DC offset level is minimised. The same process occurs in error correction circuit 5' except using signal $\underline{c}$ and switch C.

An alternative DC removal, noise detector and error correction system may be realised by replacing the DC de-coupling circuit 6 and the phase sensitive detector 7 with the circuit arrangement shown in Figure 11A.

The output from the filter circuit 4 is fed along two paths 23, 24, each path having a switch 25, 26 controlled by switching signals $\underline{a}$ and $\underline{b}$ respectively and a storage capacitor 27, 28. The output from the two paths is fed into a differential amplifier 29. The outputs from each path and the differential amplifier are shown in Figure 11B.

In this system, the output of the differential amplifier is monitored by the noise detection circuit 8 which triggers the switch 22 in the error correction circuit 5 (described in detail above) in response to any detected noise to refresh the potential difference acrcss the capacitor 20. This system therefore overcomes the disadvantages of DC de-coupling circuits which can cause signal distortion. Also, this system dispenses with the large de-coupling capacitor which takes a relatively long time to charge to the DC offset level.

To calculate a true impedance value of the loop a several stage process is needed. First the resistive component is measured. Next a 90° phase shift signal can be applied to the filter circuit control relative to the test current control circuit. This gives a result which is a function of the impedance. By using the calculated resistive result the inductive component can be evaluated, and thus the true loop impedance can be calculated. In practice this is not usually necessary as the inductive impedance is minimal.

## Claims

1. A method of testing a loop impedance in a circuit breaker protected AC circuit comprising the steps of arranging a test current of less than the circuit breaker trigger current rating to flow around the loop, the test current having a frequency $F_o$ directly synchronised with an AC supply signal, the frequency $F_o$ being given by:-

$$F_o = F_m/N$$

where $F_m$ is the frequency of the AC supply signal and N is a positive integer equal to or larger than 2, and isolating and detecting a test voltage signal which develops due to the test current, using an N-path filter having a centre frequency equal to

$F_o$ and directly syncronised with the AC supply signal to reject the AC supply signal and its harmonics to isolate the test voltage signal.

2. A method according to claim 1, in which a test current less than or equal to half the rated circuit breaker trigger current is used as the test current.

3. A method according to claim 1 or 2, in which the test current is substantially 15 mA.

4. An apparatus for testing a circuit breaker protected AC circuit to determine a loop impedance comprising a test current supply means (1) which is capable of supplying a test current directly synchronised to an AC supply signal of less than the circuit breaker trigger current rating, the test current having a frequency $F_o$ given by:-

$$F_o = F_m/N$$

where $F_m$ is the frequency of the AC supply signal and N is a positive integer equal to or larger than 2, an N-path filter (4) having a centre frequency equal to $F_o$ and directly synchronised with the AC supply signal to reject the AC supply signal and its harmonics for isolating a test voltage signal which develops due to the test current, and detection means (5, 6, 7, 8) for detecting the test voltage signal.

5. An apparatus according to claim 4, in which the N-path filter (4) is a series switched N-path filter having a centre frequency $F_o$ comprising a plurality of paths (15, 16) with each path including an input switch and an output switch, in which each path has its input switch and output switch driven out of phase and each switch is synchronised with one other switch in another path.

6. An apparatus according to claim 5, in which the N-path filter comprises two paths (15, 16) in which the input switch (A, B) in each path is cross synchronised with the output switch (B, A) of the other path and $F_o = 25$ Hz.

7. An apparatus according to any of claims 4 to 6, comprising a test current supply means (1) which generates a 50 Hz, fifty percent duty cycle, 15 mA (rms) current utilising alternate halves of a 240 V AC mains supply cycle.

8. An apparatus according to claim 7, further comprising a mains synchronisation circuit (2) which controls the test current signal output of the test current supply means (1) and generates a centre frequency signal which is synchronised with the 50 Hz mains signal and controls the operation of the N-path cross synchronised filter (4).

9. An apparatus according to any of claims 6 to 8, when dependent on claim 6, in which one path (15) of the two path filter (4) includes a variable resistor (17) to enable the RC ratios of the two input paths (14, 16) of the filter (4) to be matched.

10. An apparatus according to any one of claims 5 to 9, further comprising a DC decoupler circuit (6) connected to the output of the filter (4) to remove a DC level.

11. An apparatus according to claim 10, wherein the output of the DC decoupler circuit (6) is connected to a phase sensitive detector (7).

12. An apparatus according to any one of claims 5 to 9, in which the test voltage output of the filter (4) is applied to two parallel circuit paths (23, 24), each path comprising a switch (25, 26) and a charging capacitor (27, 28) coupled to earth wherein the switches in each path are driven out of phase with respect to one another and the output of each path is connected to a differential amplifier (29) to remove a DC level.

13. An apparatus according to any one of claims 4 to 12, further comprising micro-processor means to calculate the loop resistance.

14. An apparatus according to any of claims 4 to 13, further comprising noise detection (8) and error correction means (5, 5') which detect if noise has occurred and adjust the magnitude of the voltage output signal from each filter path (15, 16) to make it approximately equal to the previous voltage output level.

15. An apparatus according to claim 14, wherein the error correction means (5, 5') for the outputs of each path of the filter comprises a memory capacitor (20) which stores the output level of a filter path (16) during the end part of an output cycle and which is selectively connected by switching means (22) controlled by the noise detection means (8) to the path capacitor (18) during the start of a following output cycle to refresh the output signal level if the signal level has changed by above a pre-determined limit since the last detected output of that path due to noise.

**Patentansprüche**

1. Verfahren zum Testen eines Schleifenwiderstandes in einer durch einen Schutzschalter geschützten Wechselstrom-Schaltung, mit den Schritten des Einrichtens eines Teststromes, der kleiner als der Auslöse-Nennwert des Schutzschalters ist und die Schleife durchfließt, wobei der Teststrom eine Frequenz $F_o$ hat, die mit einem Wechselstrom-Zuführsignal direkt synchronisiert ist und die Frequenz $F_o$ gegeben ist durch:

$$F_o = F_m/N$$

wobei $F_m$ die Frequenz des Wechselstrom-Zuführsignals und N eine positive ganze Zahl größer oder gleich 2 ist, und des Isolierens sowie Erfassens eines Testspannungssignals, das sich aufgrund des Teststroms entwickelt, unter Verwendung eines N-Wegefilters, der eine Mittenfrequenz gleich $F_o$ hat und mit dem Wechselstrom-Zuführsignal direkt synchronisiert ist, um das Wechselstrom-Zuführsignal und dessen Harmonische zurückzuweisen und so das Testspannungssignal zu isolieren.

2. Verfahren nach Anspruch 1, bei dem ein Teststrom kleiner oder gleich der Hälfte des Schutzschalterauslösungs-Stromnennwertes als Teststrom benutzt wird.

3. Verfahren nach Anspruch 1 oder 2, bei dem der Teststrom im wesentlichen 15 mA beträgt.

4. Vorrichtung zum Testen einer durch einen Schutzschalter geschützten Wechselspannungsschaltung zum Bestimmen einer Schleifenimpedanz, welche umfaßt ein Teststrom-Zuführmittel (1), das fähig ist, einen Teststrom zuzuführen, der mit einem Wechselstrom-Zuführsignal direkt synchronisiert ist und der kleiner als der den Schutzschalter auslösende Nennstrom ist, wobei der Teststrom eine Frequenz $F_o$ hat, die gegeben ist durch:

$$F_o = F_m/N$$

wobei $F_m$ die Frequenz des Wechselstrom-Zuführsignals und N eine positive ganze Zahl größer oder gleich 2 ist, ein N-Wegefilter (4), das eine Mittenfrequenz gleich $F_o$ hat und mit dem Wechselstrom-Zuführsignal direkt synchronisiert ist, um das Wechselstrom-Zuführsignal und dessen Harmonische zurückzuweisen und so ein Testspannungssignal zu isolieren, das sich infolge des Teststroms entwickelt, und ein Erfassungsmittel (5, 6, 7, 8) zum Erfassen des Testspannungssignals.

5. Vorrichtung nach Anspruch 4,. bei der das Isoliermittel ein reihengeschaltetes N-Wegefilter (4) ist, das eine Mittenfrequenz $F_o$ hat und eine Vielzahl von Wegen (15, 16) enthält, von denen jeder Weg einen Eingangsschalter und einen Ausgangsschalter enthält, wobei in jedem Weg der Eingangsschalter und Ausgangsschalter außer Phase angesteuert wird und jeder Schalter mit einem anderen Schalter in einem anderen Weg synchronisiert ist.

6. Vorrichtung nach Anspruch 5, bei der das N-Wegefilter zwei Wege (15, 16) umfaßt, bei denen der Eingangsschalter (A, B) in jedem Weg mit dem Ausgangsschalter (B, A) des anderen Weges kreuzsynchronisiert ist und $F_o$ gleich 25 Hz ist.

7. Vorrichtung nach einem der Ansprüche 4 bis 6, die ein Teststrom-Zuführmittel (1) umfaßt, welches einen Strom mit 50 Hz, 50% Einschaltverhältnis und einem Effektivwert von 15 mA erzeugt mit Benutzung abwechselnder Hälften eines 240V-Wechselstromnetzversorgungszyklus.

8. Vorrichtung nach Anspruch 7, die weiter eine Netzsynchronisationsschaltung (2) umfaßt, welche das Teststrom-Ausgangssignal des Teststrom-Versorgungsmittels (1) steuert und ein Mittenfrequenzsignal erzeugt, das mit dem 50Hz-Netzsignal synchronisiert ist und den Betrieb des kreuzsynchronisierten N-Wege-Filters (4) steuert.

9. Vorrichtung nach einem der Ansprüche 6 bis 8, wenn abhängig von Anspruch 6, bei der ein Weg (15) des Zweiwegefilters (4) einen variablen Widerstand (17) enthält, um die Anpassung der RC-Verhältniswerte der beiden Eingangswege (14, 16) des Filters (4) aneinander zu ermöglichen.

10. Vorrichtung nach einem der Ansprüche 5 bis 9, die weiter umfaßt eine Gleichspannungs-Entkoppelschaltung (6), die zum Entfernen eines Gleichspannungspegels an den Ausgang des Filters (4) angeschlossen ist.

11. Vorrichtung nach Anspruch 10, bei der das Ausgangssignal der Gleichspannungs-Entkoppelschaltung (6) an einen phasenempfindlichen Detektor (7) angelegt ist.

12. Vorrichtung nach einem der Ansprüche 5 bis 9, bei der das Testspannungs-Ausgangssignal des Filters (4) an zwei parallele Schaltungswege (23, 24) angelegt ist, von denen jeder Weg einen Schalter (25, 26) und einen mit Erde gekoppelten Ladekondensator (27, 28) umfaßt, wobei die Schalter in jedem Weg mit Bezug aufeinander außer Phase angesteuert werden und das Ausgangssignal jedes Weges zum Entfernen eines Gleichspannungspegels an einen Differentialverstärker (29) angelegt ist.

13. Vorrichtung nach einem der Ansprüche 4 bis 12, die weiter Mikroprozessormittel zum Errechnen des Schleifenwiderstandes umfaßt.

**14.** Vorrichtung nach einem der Ansprüche 4 bis 13, die weiter Rauscherfassungs- (8) und Fehlerkorrekturmittel (5, 5') umfaßt, welche erfassen, ob Rauschen aufgetreten ist, und die Größe des Spannungsausgangssignals von jedem Filterweg (15, 16) erfassen, um es annähernd gleich dem vorhergehenden Ausgangsspannungspegel zu machen.

**15.** Vorrichtung nach Anspruch 14, bei der das Fehlerkorrekturmittel (5, 5') für die Ausgangssignale jedes Weges des Filters einen Speicherkondensator (20) umfassen, der den Ausgangspegel eines Filterweges (16) während des Endteils eines Ausgangszyklus speichert und der wahlweise durch von dem Rauscherfassungsmittel (8) gesteuerte Schaltmittel (22) während des Beginns eines nachfolgenden Ausgangszyklus mit dem Wegekondensator (18) verbunden wird, um den Ausgangssignalpegel aufzufrischen, wenn der Signalpegel sich seit dem zuletzt erfaßten Ausgangssignal dieses Weges infolge von Rauschen um mehr als einen vorgegebenen Grenzwert geändert hat.

## Revendications

**1.** Procédé d'essai d'une impédance de boucle dans un circuit de courant alternatif protégé par un disjoncteur, comprenant les étapes :

consistant à faire en sorte qu'un courant d'essai inférieur à la valeur nominale du courant de déclenchement de disjoncteur s'écoule dans la boucle, le courant d'essai ayant une fréquence $F_o$ directement synchronisée avec un signal d'alimentation en courant alternatif, la fréquence $F_o$ étant donnée par :

$$F_o = F_m/N$$

où $F_m$ est la fréquence du signal d'alimentation en courant alternatif et N est nombre entier positif égal ou supérieur à 2 ; et

d'isolement et de détection d'un signal de tension d'essai qui prend naissance en raison du courant d'essai, en utilisant un filtre à N trajets ayant une fréquence centrale égale à $F_o$ et directement synchronisée avec le signal d'alimentation en courant alternatif, pour rejeter le signal d'alimentation en courant alternatif et ses harmoniques pour isoler le signal de tension d'essai.

**2.** Procédé selon la revendication 1, dans lequel on utilise, comme courant d'essai, un courant d'essai inférieur ou égal à la moitié du courant nominal de déclenchement de disjoncteur.

**3.** Procédé selon la revendication 1 ou 2 dans lequel le courant d'essai est sensiblement de 15 mA.

**4.** Appareil pour essayer un circuit alternatif protégé par disjoncteur pour déterminer une impédance de boucle, comprenant :

un moyen (1) de délivrance de courant d'essai qui est capable de délivrer un courant d'essai, directement synchronisé sur un signal d'alimentation en courant alternatif, inférieur à la valeur nominale du courant de déclenchement de disjoncteur, le courant d'essai ayant une fréquence $F_o$ donnée par

$$F_o = F_m/N$$

où $F_m$ est la fréquence du signal d'alimentation en courant alternatif et N est nombre entier positif égal ou supérieur à 2 ; et
un filtre (4) à N trajets ayant une fréquence centrale égale à $F_o$ et directement synchronisée avec le signal d'alimentation en courant alternatif, pour rejeter le signal d'alimentation en courant alternatif et ses harmoniques pour isoler un signal de tension d'essai qui prend naissance en raison du courant d'essai ; et
un moyen (5, 6, 7, 8) de détection destiné à détecter le signal de tension d'essai.

**5.** Appareil selon la revendication 4, dans lequel le filtre (4) à N trajets est un filtre à N trajets commuté en série ayant une fréquence centrale $F_o$ comprenant plusieurs trajets (15, 16) chaque trajet incluant un commutateur d'entrée et un commutateur de sortie, dans lequel chaque trajet a son commutateur d'entrée et son commutateur de sortie attaqués de façon déphasée, et dans lequel chaque commutateur est synchronisé avec un autre commutateur dans un autre trajet.

**6.** Appareil selon la revendication 5, dans lequel le filtre à N trajets comprend deux trajets (15, 16), le commutateur d'entrée (A, B) de chaque trajet étant synchronisé de façon croisée avec le commutateur de sortie (B, A) de l'autre trajet, et dans lequel $F_o =$ 25 Hz.

**7.** Appareil selon l'une quelconque des revendications 4 à 6, comprenant un moyen (1) de délivrance de courant d'essai qui produit un courant de 15 mA (efficaces), d'un rapport cyclique de cinquante pour cent, de 50 Hz, en utilisant les moitiés alternées d'un cycle d'alimentation du secteur alternatif de 240 V.

**8.** Appareil selon la revendication 7, comprenant, en outre, un circuit (2) de synchronisation de secteur qui commande la sortie de signal de courant d'essai du moyen (1) de délivrance de courant d'essai et qui produit un signal de fréquence centrale qui est synchronisé avec le signal du secteur de 50 Hz et qui commande le fonctionnement du filtre (4) synchronisé de façon crolsée à N trajets.

**9.** Appareil selon l'une quelconque des revendications 6 à 8, lorsqu'elles dépendent de la revendication 6, dans lequel un trajet (15) du' filtre (4) à deux trajets comprend une résistance variable (17) pour permettre d'adapter les rapports RC des deux trajets d'entrée (14, 16) du filtre (4).

**10.** Appareil selon l'une quelconque des revendicatlons 5 à 9, comprenant en outre, un circuit (6) de découplage de courant continu connecté à la sortie du filtre (4) pour éliminer un niveau de courant continu.

**11.** Appareil selon la revendication 10, dans lequel la sortie du circuit (6) de découplage de courant continu est connectée à un détecteur (7) sensible à la phase.

**12.** Appareil selon l'une quelconque des revendications 5 à 9, dans lequel la sortie de tension d'essai du filtre (4) est appliquée à deux trajets de circuit parallèles (23, 24), chaque trajet comprenant un commutateur (25, 26) et un condensateur de charge (27, 28) raccordé à la terre, dans lequel les commutateurs dans chaque trajet sont attaqués de façon déphasée l'un par rapport à l'autre, et dans lequel la sortie de chaque trajet est connectée à un amplificateur différentiel (29) pour éliminer un niveau de courant continu.

**13.** Appareil selon l'une quelconque des revendications 4 à 12, comprenant, en outre, un moyen microprocesseur pour calculer la résistance de boucle,

**14.** Appareil selon l'une quelconque des revendications 4 à 13, comprenant, en outre, une détection de bruit (8) et un moyen (5, 5') de correction d'erreurs qui détectent si du bruit s'est produit et qui ajustent l'amplitude du signal de sortie de tension de chaque trajet (16, 16) de filtre pour la rendre à peu près égale au niveau antérieur de sortle de tension.

**15.** Appareil selon la revendication 14, dans lequel le moyen (5, 5') de correction d'erreurs pour les sorties de chaque trajet du filtre comprend un condensateur (20) de mémorisation qui mémorise le niveau de sortie d'un trajet (16) de filtre pendant la partie finale d'un cycle de sortie et qui est connecté de manière sélective, par un moyen (22) de commutation commandé par le moyen (8) de détection de bruit, au condensateur (18) de trajet pendant le début d'un cycle de sortie suivant, pour rafraîchir le niveau de sortie si le niveau de signal a changé, en raison du bruit, de plus qu'une limite prédéterminée, depuis la dernière sortie détectée de ce trajet.

## Fig.1

## Fig. 2

## Fig.5A

*Fig.3A*

240V AC 50HZ

1

13

11

12

b

9

10

14

*Fig.3B*

240V
AC
50HZ

$I_T$

*Fig.4*

3

4

16

13

A

B

a

18

b

B

A

b

17

19

a

15

14

Fig.5B

Fig.6

EP 0 706 663 B2

12

*Fig. 7*

*Fig.8*

*Fig.9*

*Fig.10*

*Fig.11A*

*Fig.11B*